# EUROPEAN PATENT APPLICATION

(11) **EP 3 503 178 A1**
(43) Date of publication of application: **26.06.2019**
(21) Application number: 17209013.6
(22) Date of filing: 20.12.2017
(51) Int. Cl.: H01L 23/495, H01L 23/492, H01L 21/60

(54) **SEMICONDUCTOR PACKAGE AND METHOD OF MANUFACTURE**

(71) Applicant: Nexperia B.V., 6534 AB Nijmegen (NL)
(72) Inventor: Yandoc, Ricardo, Stockport, Greater Manchester SK7 5BJ (GB); Brown, Adam, Stockport, Greater Manchester SK7 5BJ (GB)
(74) Representative: Crawford, Andrew

(57) **Abstract**

This disclosure relates to a semiconductor package and a method of manufacturing a semiconductor package. The semiconductor package, comprises: a leadframe having a die attach portion (104) and a lead portion (106); a semiconductor die (102) mounted on the die attach portion (104), the semiconductor die (102) having a contact terminal arranged thereon; a clip portion (108) having: a first tab portion (110) receivably mounted in a hole in the lead portion (106), and a second tab portion (114) arranged on either side of the first tab portion (110), wherein the second tab portions (114) are fixedly mounted to connect the clip portion (108) to the lead portion (106).

## Description

### FIELD

The present disclosure relates to a leadframe for a semiconductor package. In particular the present disclosure relates to a clip based package.

### BACKGROUND

Semiconductor packages use so-called clips to provide electrical external connections to terminals on the semiconductor die. Clip based packages typically have improved electrical, mechanical and thermal performance when compared with packages using wire based, so-called wire bond, connections.

Whilst clip based packages have improved reliability and performance when compared to wire bond arrangements, they can suffer from issues related to consistent manufacturability. For example, at one end the clips are typically attached to the terminals of the semiconductor packages using a solder material. At an opposite end the clips may also be attached to the external lead using a solder material. A process known as reflow is then use to form the connections of the clip to the terminals of the semiconductor packages and to the external lead. However, effects such as outgassing can cause the clip to move relative to the terminals of the semiconductor package and and/or the external lead which result in tilting or rotation of the clip. Tilting or rotation of the clip may result in long-term package reliability or a complete failure of the package. In particular, tilting of the clip also known as tomb-stoning, that is movement of the clip upwards such that end of the clip is raised with respect to the terminal of the semiconductor die may be caused by the surface tension of the solder pulling the clip upwards.

### SUMMARY

According to an embodiment there is provided a semiconductor package, comprising: a leadframe having a die attach portion and a lead portion; a semiconductor die mounted on the die attach portion, the semiconductor die having a contact terminal arranged thereon; a clip portion having: a first tab portion receivably mounted in a hole in the lead portion, and a second tab portion arranged on either side of the first tab portion, wherein the second tab portions are fixedly mounted to connect the clip portion to the lead portion.

The first tab portion may be angled with respect to the lead portion such that the first tab portion is received by the hole in the lead portion. The length of the first tab portion may be equal to or longer than the thickness of the lead portion. The first tab portion is angled with respect to the lead portion by approximately 90 degrees. The second tab portions may be substantially parallel to the lead portion and the angled with respect the first tab portion by approximately 90 degrees.

The clip portion may be further mounted to the contact terminal of the semiconductor die. The clip portion may further comprise one or more holes adjacent to the first tab portion configured and arranged to allow for venting of gasses. The tab portion may be tapered such that it is thicker at an end proximal the clip portion and thinner at an end distal the clip portion.

According to an embodiment there is also provided method of manufacturing a semiconductor package, the method comprising: providing a leadframe having a die attach portion and a lead portion; mounting a semiconductor die on the die attach portion, the semiconductor die having a contact terminal arranged thereon; providing a clip portion having a first tab portion and a second tab portion arranged on either side of the first tab portion, recievably mounting the first tab portion in a hole in the lead portion and fixedly mounting the second tab portions to the lead portion.

The first tab portion may be angled with respect to the lead portion and the hole in the lead portion receives the first tab portion. The first tab portion may extends through the hole. The first tab portion may be angled with respect to the lead portion by approximately 90 degrees.

The second tab portions may be arranged substantially parallel to the lead portion and angled with respect the first tab portion by approximately 90 degrees. The clip portion may be mounted to the contact terminal of the semiconductor die. The method may further comprise providing one or more holes in the clip portion adjacent to the first tab portion configured and arranged to allow for venting of gasses.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1a illustrates a plan view of a semiconductor device, without moulding, according to an embodiment;
Figure 1b illustrates a side view of the semiconductor device, without moulding, according to an embodiment; and
Figures 2a to 2f illustrates process steps for manufacturing the semiconductor device in accordance with embodiments.

### DETAILED DESCRIPTION

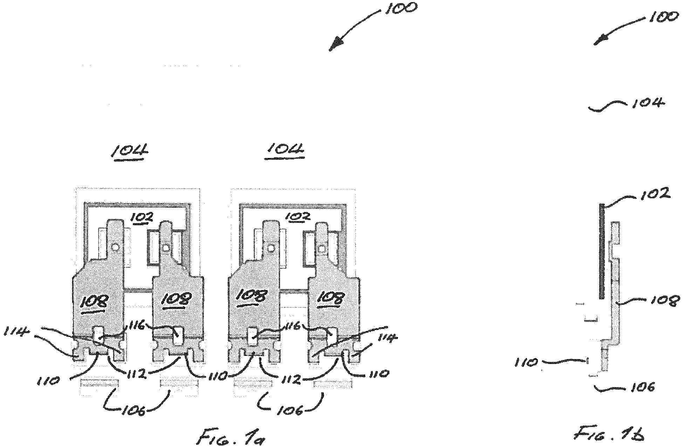

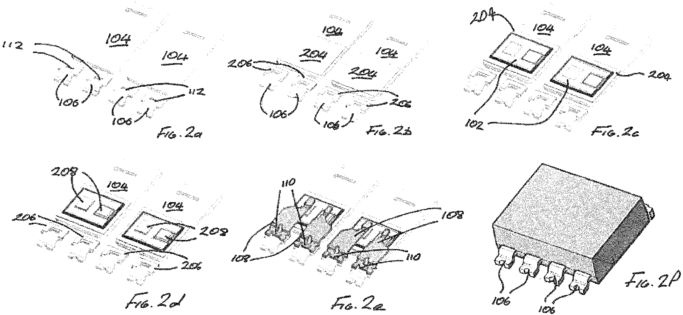

Figure 1a illustrates a plan view of a semiconductor package 100 according to an embodiment. For the purposes of clarity and explanation a moulding compound or material is not illustrated, however the skilled person will appreciate that this may be formed in any appropriate manner as illustrated for example in Figure 2f.

In overview, the semiconductor device comprises one or more semiconductor dies 102 mounted on a respective die attach portion 104 of a lead frame. A clip portion 108, electrically connects a contact terminal of the semiconductor die 102 to a lead portion 106 of the lead frame. The clip portion 108 includes a first tab portion 110 which is configured and arranged to be engageably received by, or mate with, a corresponding a hole 112 in the lead portion 106. The clip portion 108 further includes second tab portions 114 arranged on either side of the first tab portion 110. The second tab portions 114 are substantially parallel to a top surface of the lead portion 106.

The first tab portion 110 may form a clearance fit with the corresponding hole 112 in the lead portion 106, such that the first tab portion 110 is slideably received by the hole 112. As discussed below, this allows the clip portion 108 to moved up or down during the reflow process, but prevents the clip portion 108 from rotating with respect to the lead portion 106 and/or the contact terminals of the semiconductor die 102. In other words, the arrangement of the first tab portion 110 with side walls of the corresponding hole 112 limits or restricts the movement of the clip portion 108 parallel to the surface of the contact terminals of the semiconductor die 102. In addition, the length of the first tab portion 110 may be such that it protrudes through the lead portion, or in other words, the length of the first tab portion 110 may be longer than the thickness of the lead portion 106 in which the hole 112 is formed, this prevents disengagement of the first tab portion 110, and thus the clip portion 108, from the lead frame 106.

Optionally, the first tab portion 110 may form a location-transition fit or an interference fit with the side walls of the hole 112.

One or more outgassing holes 116 may also be provided in the clip portion 108, adjacent to the first tab portion 110 which allow venting of gasses during the solder reflow process, as discussed in more detail below. The outgassing holes 116 allow reflow gasses to be released thereby preventing a build-up of gaseous pressure under the clip portion which may have the effect of forcing the clip portion 108 upwards.

A solder material may be provided between the second tab portions 114 and the lead portion 106. Due to the arrangement of a second tab portions 114 on either side of the first tab portion 110, any imbalance in forces due to surface tension generated between the solder and the second tab portions 114 will be balanced thus preventing the clip from tilting upwards, that is tomb-stoning, with respect to the contact terminals of the semiconductor die 102. Furthermore, the second tab portions 114 are arranged to be substantially parallel with respect to an upper surface of the lead portion 106. This has the effect that any burrs or raised edges which may remain in the second tab portions 114 do not affect the height of the clip portion 108 as it is mounted on the lead portion 106. In addition, this has the added advantage that a deburring process, that is, the removal of burrs or raised edges is not required.

Figure 1b is a side view of the semiconductor device of Figure 1a, according to an embodiment. As illustrated in Figure 1b the first tab portion 110 extends into and through the hole 112 in the lead portion 106. The first tab portion 110 may extend through the hole 112 to prevent disengagement of the first tab portion 110, and thus the clip portion 108, from the lead frame 106, as discussed above.

The first tab portion 110, as it extends into or through the hole, is bent or angled with respect to the second tab portions 114. Preferably, the first tab portion 110 is bent or angled by 90 degrees (± 5 degrees), however, optionally, the first tab portion 110 may bent or angled such that it is received by the hole 112 in the lead portion 106.

The end of the first tab portion 110, that is the end which is arranged to be inserted into the hole 112 in the lead portion 106 may be tapered. This allows for easier insertion of the clip portion 108 into the lead portion 106 during assembly.

Figures 2a to 2f illustrate the various process steps in manufacturing the semiconductor device 100 in accordance with an embodiment.

Starting with Figure 2a, a lead frame comprising a die attach portion 104 and a plurality of lead portions 106 is provided. The die attach portion 104 and lead portions 106 may be formed of any appropriate material such as copper. In addition, each of the lead portions comprise at least one hole or slot 112, which as discussed above is arranged receive the first tab portion 110 of the clip portion 108.

In the next step as illustrated in Figure 2b a die attach material 204 is dispensed onto the die attach portion 104. The die attach material 204 is arranged for fixedly mounting the semiconductor die 102 to the die attach portion 104. The die attach material may be any appropriate adhesive material such as a solder or conductive adhesive. In addition, a clip portion attachment material 206 may be dispensed onto the lead portion 106. The clip portion attachment material 206 may be arranged to fixedly mount the clip portion 108 to the lead portion 106. Specifically, the clip attach material 206 is arranged on the lead portion such that it fixedly contacts the second tab portions 114 arranged on either side of the first tab portion 110. The clip attach material 206 may be a solder material as discussed above.

Dispensing of the die attach material 204 may optionally be carried out simultaneously with the dispensing of the clip attach material 206. Optionally the die attach material 204 may be formed of the same material as the clip attach material 206.

Following dispensing of the die attach material 204 and the clip attach material 206, the semiconductor die 102 is attached to the die attach portion 104 of the lead frame as shown in Figure 2c. Following placement of the semiconductor die 102, a contact terminal attach material 208 is dispended on the contact terminals of the semiconductor die 102 for electrical and mechanical connection of the clip portion 106 to the semiconductor die 102. The die attach material 204 may be applied by any appropriate process such as solder printing or solder dispense.

Once the semiconductor die 102 is in place on the die attach portion 104, the contact terminal attach material 208 is arranged on the contact terminals of the semiconductor die as illustrated in Figure 2d. The clip portion 108 may then be arranged on the contact terminals and on the lead portion 106 as illustrated in Figure 2e.

The first tab portion 110 of the clip portion 108 is inserted into the hole 112 of the lead portion 106 and this aligns the clip portion 108 with the contact terminals of the semiconductor die 102 and also aligns the second tab portions 114 the lead portion 106 and thus with the clip attach material 206 arranged on the lead portion 106. This arrangement results in the second tab portions 114 which are parallel or substantially parallel with the top surface of the lead portion 106 and the weight of the clip portion 108 together with the amount of solder dispensed on the lead portion 106 ensures that the thickness of the solder connecting the second tab portions 114 to the lead portion 106 will also be uniform. Typically, the solder thickness will be uniform and in the region of 1 µm to 5 µm. The specific solder thickness will be dependent on the volume of the solder dispensed.

Following the attachment of the clip portion 108 to the contact portion of the semiconductor die 102 and the lead portion 106, the assembly undergo goes solder re-flow to solidify the clip attach material 206, the contact terminal attach material 208 and the die attach material 204. Following reflow, second tab portions 114 are substantially parallel to a top surface of the lead portion 106. Gasses generated between the clip portion and the lead portion during the reflow process may be vented by one or more outgassing holes 116 provided in the clip portion.

Following reflow, the assembly may be packaged in a mould material as illustrated Figure 2f.

Whilst the above embodiments illustrate a so-called dual die arrangement, comprising two semiconductor dies 102, with two corresponding die attach portions 104 and a plurality of lead portions 106, the skilled person will appreciate that present disclosure may also relate to single or multi die arrangements as required by the specific functionality of the semiconductor device. As such, embodiments may therefore include at least one semiconductor die 102, at least one die attach portion 104 and at least one lead portion 106.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalisation thereof irrespective of whether or not it relates to the claimed invention or mitigate against any or all of the problems addressed by the present invention. The applicant hereby gives notice that new claims may be formulated to such features during prosecution of this application or of any such further application derived there from. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

Term "comprising" does not exclude other elements or steps, the term "a" or "an" does not exclude a plurality. Reference signs in the claims shall not be construed as limiting the scope of the claims.

## Claims

1. A semiconductor package, comprising:
a leadframe having a die attach portion and a lead portion;
a semiconductor die mounted on the die attach portion, the semiconductor die having a contact terminal arranged thereon;
a clip portion having: a first tab portion receivably mounted in a hole in the lead portion, and a second tab portion arranged on either side of the first tab portion, wherein the second tab portions are fixedly mounted to connect the clip portion to the lead portion.

2. The semiconductor package of claim 1, wherein first tab portion is angled with respect to the lead portion such that the first tab portion is received by the hole in the lead portion.

3. The semiconductor package of claims 1 or 2, wherein the length of the first tab portion is equal to or longer than the thickness of the lead portion.

4. The semiconductor package of claims 1 to 3, wherein the first tab portion is angled with respect to the lead portion by approximately 90 degrees.

5. The semiconductor package of any preceding claim, wherein the second tab portions are substantially parallel to the lead portion and the angled with respect the first tab portion by approximately 90 degrees.

6. The semiconductor package of any preceding claim wherein the clip portion is further mounted to the contact terminal of the semiconductor die.

7. The semiconductor package of any preceding claim wherein the clip portion further comprises one or more holes adjacent to the first tab portion configured and arranged to allow for venting of gasses.

8. The semiconductor package of any preceding claim wherein the tab portion is tapered such that it is thicker at an end proximal the clip portion and thinner at an end distal the clip portion.

9. A method of manufacturing a semiconductor package, the method comprising:
providing a leadframe having a die attach portion and a lead portion;
mounting a semiconductor die on the die attach portion, the semiconductor die having a contact terminal arranged thereon;
providing a clip portion having a first tab portion and a second tab portion arranged on either side of the first tab portion,
recievably mounting the first tab portion in a hole in the lead portion and fixedly mounting the second tab portions to the lead portion.

10. The method of claim 9, wherein the first tab portion is angled with respect to the lead portion and the hole in the lead portion receives the first tab portion.

11. The method of claims 9 or 10, wherein the first tab portion extends through the hole.

12. The method of claims 9 to 11, further comprising angling the first tab portion with respect to the lead portion by approximately 90 degrees.

13. The method of claims 9 to 12, further comprising arranging the second tab portions substantially parallel to the lead portion and angled with respect the first tab portion by approximately 90 degrees.

14. The method of claims 9 to 13, further comprising mounting the clip portion to the contact terminal of the semiconductor die.

15. The method of claims 9 to 14, further comprising providing one or more holes in the clip portion adjacent to the first tab portion configured and arranged to allow for venting of gasses.
